# EUROPÄISCHE PATENTSCHRIFT

(11) **EP 2 442 977 B1**
(45) Veröffentlichungstag und Bekanntmachung des Hinweises auf die Patenterteilung: **29.11.2017**
(21) Anmeldenummer: 10721833.1
(22) Anmeldetag: 10.06.2010
(51) Int. Cl.: B32B 17/10, C03C 27/12, H01L 31/048

(54) **VERBUNDGLASSCHEIBE UND DEREN VERWENDUNG**
LAMINATED GLAZING AND ITS USE
VITRAGE FEUILLETÉ ET SON UTILISATION

(30) Priorität: 15.06.2009 DE 102009025972
(43) Veröffentlichungstag der Anmeldung: 25.04.2012
(73) Patentinhaber: Sage Electrochromics, Inc., Faribault, MN 55021 (US)
(72) Erfinder: GIRON, Jean-Christophe, MN 55436 Edina (US); ANDREAU-WIEDENMAIER, Annabelle, 52074 Aachen (DE); PHAN, Dang, Cuong, 52062 Aachen (DE)
(74) Vertreter: Lendvai, Tomas
(86) Internationale Anmeldenummer: PCT/EP2010/058167
(87) Internationale Veröffentlichungsnummer: WO 2010/145986

(56) Entgegenhaltungen:
- EP-A1- 2 151 884
- WO-A1-2007/093823
- DE-A1-102004 022 008
- US-A- 2 640 904
- US-A- 3 317 710

## Beschreibung

Die vorliegende Erfindung betrifft eine neue Verbundglasscheibe mit einer Schichtstruktur.

Weiter betrifft die vorliegende Erfindung eine neue Verwendung einer Verbundglasscheibe.

In der Patentanmeldung DE 10 2006 042 538 A1 ist ein Verbundglas, enthaltend ein Dünnglas mit einer Dicke kleiner oder gleich 1,5 mm, offenbart. Das Verbundglas weist eine funktionale Beschichtung auf und ist mit einer Anzahl von weiteren Gläsern und Polymerschichten verbunden. Die Dicken und Materialien der Gläser und haftvermittelnden Schichten sind derart ausgestaltet, dass Scherkräfte an der Grenzfläche Glas / Verbundmaterial beim Einwirken einer äußeren Kraft oder bei Temperaturänderungen kompensiert werden.

Aus der US 2006/0127679 A1 ist ein Glaslaminat mit äußeren Glasschichten und einem Glaskern bekannt, wobei die äußeren Glasschichten einen ersten thermischen Ausdehnungskoeffizienten und der transparente Glaskern einen zweiten, höheren thermischen Ausdehnungskoeffizienten aufweisen. Die äußeren Glasschichten weisen mechanische Druckspannungen von größer 6,9 MPa auf. Der Glaskern weist Zugspannungen von weniger als 27,6 MPa, bevorzugt weniger als 6,9 MPa auf. Der Aufbau beinhaltet wenigstens drei Glasschichten. Durch bevorzugte Kombinationen der thermischen Ausdehnungskoeffizienten können bevorzugte mechanische Spannungen im Glaslaminat erzielt werden.

Dabei ist es allerdings nötig, thermisch vorbehandelte Gläser, Gläser mit unüblichen Glasdicken und / oder mehr als zwei Glasscheiben zu verwenden um die mechanischen Spannungen gezielt einzustellen.

Die EP 2 151 884 A1 und die DE 10 2004 022088 A1 lehren, Glasscheiben mit gleichem thermischen Ausdehnungskoeffizienten für Verbundscheiben zu wählen.

Der vorliegenden Erfindung liegt die Aufgabe zugrunde, ein verbessertes Verbundglas bereitzustellen, welches die Nachteile herkömmlicher Verbundgläser nicht mehr Glasbruch der Verbundglasscheibe, beispielweise durch Temperaturänderungen oder durch das Einwirken äußerer Kräfte, sollen verhindert werden.

Auch liegt der vorliegenden Erfindung die Aufgabe zu Grunde, eine neue Verwendung der Verbundglasscheibe bereitzustellen.

Diese und weitere Aufgaben werden nach dem Vorschlag der Erfindung durch den Aufbau mit den Merkmalen des unabhängigen Patentanspruchs gelöst. Vorteilhafte Ausgestaltungen der Erfindung sind durch die Merkmale der Unteransprüche gegeben.

Erfindungsgemäß ist eine Verbundglasscheibe vorgesehen, umfassend
a) ein Substratglas mit einer Dicke von 0,3 mm bis 25 mm,
b) mindestens eine auf dem Substratglas aufgebrachte Schichtstruktur,
c) mindestens eine auf der Schichtstruktur aufgebrachte Polymerschicht mit einer Schichtdicke von 0,2 mm bis 10 mm,
d) ein Deckglas mit einer Dicke von 1,3 mm bis 25 mm auf der Polymerschicht,
wobei im Temperaturbereich von -40 °C bis +90 °C die maximale mechanische Spannung der Verbundglasscheibe kleiner oder gleich 7 MPa ist, und wobei das Substratglas ein Borosilikatglas ist mit einem mittleren thermischen Ausdehnungskoeffizienten von 44 x 10⁻⁷ K⁻¹ und wobei das Deckglas ein Borosilikatglas ist mit einem mittleren thermischen Ausdehnungskoeffizienten von 50 x 10⁻⁷ K⁻¹.

In Gebäuden und Fahrzeugen werden zunehmend Verbundverglasungen mit Schichtstrukturen eingesetzt, insbesondere mit elektrisch aktiven Schichtstrukturen. Zum Schutz vor äußeren Einflüssen, insbesondere vor äußeren mechanischen Kräften, Temperaturen im Bereich von üblicherweise -40°C bis 90°C und Feuchtigkeit sowie zur galvanischen Trennung der elektrisch aktiven Schichtstrukturen von der Umgebung, befinden sich die Schichtstrukturen auf den innen liegenden Flächen der Verbundverglasungen, an der Grenzfläche zwischen einer haftvermittelnden Polymerschicht und den Glasscheiben.

Die Anforderungen an beschichtete Verbundglasscheiben in Fahrzeugen sind beispielsweise aus der ECE-R 43 (Regel 43: Einheitliche Vorschriften für die Genehmigung der Sicherheitsverglasungswerkstoffe und ihres Einbaus in Fahrzeuge, 2004) bekannt. Anforderungen an Verbundglasscheiben im Bauwesen sind in der DIN EN 12543 beschrieben. Die Anforderungen zur Bauartzulassung von beschichteten Verbundgläsern sind beispielsweise in Normen zu Dünnschicht-Photovoltaik-Modulen, wie DIN EN 61646 und DIN EN 61250 beschrieben.

Es ist bekannt, dass die Glasscheiben der Verbundglasscheiben bevorzugt auch als Substrat für die Schichtstruktur genutzt werden. Die Glasscheibe, die als Substrat für die Schichtstruktur dient, wird als Substratglas bezeichnet. Die weitere Glasscheibe im Verbundglas wird als Deckglas bezeichnet.

Verbundglasscheiben sind gewöhnlich einem Temperaturbereich von -40°C bis 90°C ausgesetzt. Innerhalb des Temperaturbereichs dürfen die mechanischen Spannungen in Verbundglasscheiben nicht oberhalb einer kritischen mechanischen Spannung liegen.

Für Verbundglasscheiben mit einer elektrisch aktiven Schichtstruktur sind je nach Eigenschaften der Schichtstruktur unterschiedliche maximale mechanische Spannungen zulässig. Bestimmende Eigenschaften für die maximalen mechanischen Spannungen in Verbundglasscheiben sind insbesondere:
a) die mechanischen Eigenspannungen und Schichtdicken von Einzelschichten der Schichtstruktur,
b) die mechanische Eigenspannung und Schichtdicke der gesamten Schichtstruktur,
c) die Haftung der Einzelschichten der Schichtstruktur untereinander und
d) die Haftung der Schichtstruktur mit dem Substratglas und / oder der Polymerschicht.

Auch werden die maximalen mechanischen Spannungen durch den gesamten Verbundaufbau und auch die Montagevorrichtung im Hinblick auf die Gefahr von Deformationen und Glasbruch aufgrund von äußeren Kräften bestimmt.

Kritische mechanische Spannungen stellen sich insbesondere bei einem Temperaturwechsel ein, wenn die mittleren thermischen Ausdehnungskoeffizienten des Deckglases, des Substratglases und der Polymerschichten nicht in geeigneter Weise aufeinander abgestimmt sind.

Im erfindungsgemäßen Aufbau sind die mittleren thermischen Ausdehnungskoeffizienten des Deckglases und des Substratglases im hohen Maße an die Erfordernisse der Schichtstrukturen angepasst. Insbesondere Scherkräfte an der Grenzfläche des Substratglases zur Polymerschicht, die die Schichtstruktur beschädigen können, werden vermieden.

Mechanische Spannungen in den Glasscheiben können mit Polariskopen oder Polarimetern gemessen werden, die mit einer speziellen Filteranordnung mechanische Spannungen durch Farbverschiebungen oder Intensitätsunterschiede sichtbar machen. Geeignete Messgeräte sind beispielsweise der "Edge stress Master" oder der "Large field strain viewer" der Fa. SHARPLESS STRESS ENGINEERS LTD oder der "GASP" der Fa. STRAINOPTICS INC.
Mechanische Eigenspannungen in den Schichtstrukturen können beispielsweise mit bekannten Methoden aus Messungen mittels Röntgendiffraktometrie oder durch Dehnmessstreifen an der Schicht ermittelt werden.

Die mechanischen Spannungen in den Verbundglasscheiben sind bei unterschiedlichen thermischen Ausdehnungskoeffizienten aufgrund jahreszeitlicher, tageszeitlicher und benutzungsabhängiger Schwankungen der Umgebungstemperaturen, sowie den Jouleschen Verlusten in der Schichtstruktur unterschiedlich hoch. Weisen die Glasscheiben, Polymerschichten und Schichtstrukturen starke Abweichungen im thermischen Ausdehnungskoeffizienten auf, verursachen Temperaturzyklen eine Erhöhung der mechanischen Spannungen der Glasscheiben und Schichtstrukturen der Verbundglasscheibe.

Mechanische Spannungen führen auch insbesondere zu Deformationen der Verbundglasscheiben. Die maximale Verbiegung kann als Maß für die Deformation angenommen werden. Die Verbiegung gibt die maximale Tiefe einer konvexen Form der Verbundglasscheibe oder Höhe einer konkaven Form der Verbundglasscheibe, bezogen auf eine gedachte planare Ebene an, die von den 4 Eckpunkten der Fläche aufgespannt wird.

In einer bevorzugten Ausführungsform weist die Verbundglasscheibe im Temperaturbereich von -40 °C bis +90 °C eine maximale Verbiegung kleiner oder gleich 16 mm auf.

Der thermische Ausdehnungskoeffizient mit der Einheit 1/K (coefficient of thermal expansion - CTE) ist eine temperaturabhängige Größe. Der mittlere thermische Ausdehnungskoeffizient für Glas berechnet sich nach ISO 7991:1987 und berücksichtigt das typische Temperaturverhalten zwischen 30°C bis 300°C.

Die Schichtstrukturen können elektrisch beschaltet und aktiv sein. Insbesondere können die Schichtstrukturen eine elektrochrome Funktion, photovoltaische, lichtemittierende und / oder Heizfunktion aufweisen. Typischerweise bestehen Schichtstrukturen aus mehreren Einzelschichten, insbesondere Dünnschichten mit einer Schichtdicke kleiner 5 µm.

Schichtstrukturen mit elektrochromer Funktion enthalten eine aktive Schicht, welche von transparenten Elektroden eingefasst sind. Geeignete Schichtstrukturen sind beispielsweise aus EP 0 831 360 B1 und US 6,747,779 B1 bekannt. Durch Anlegen einer externen Spannung werden Ladungsträger in die aktive Schicht transportiert, was dazu führt, dass die aktive Schicht ihre Transparenz gegenüber sichtbarem Licht verändert. Wird anschließend eine umgekehrte Spannung angelegt, wird die Ladungsträgerwanderung rückgängig gemacht, so dass die ursprüngliche Transparenz wiederhergestellt wird. Die Dicken der elektrochromen Schichtstruktur betragen bevorzugt 500 nm bis 1 mm.

Lichtemittierenden Schichtstrukturen basieren auf Dünnschichtsystemen oder Folien aus Halbleitermaterial, insbesondere organische Leuchtdioden und Elektrolumineszenzmaterialien, die Licht im definierten Wellenlängenbereich nach Anlegen einer elektrischen Spannung aussenden. Die lichtemittierenden Schichtstrukturen weisen Schichtdicken von 500 nm bis 2 mm auf.

Schichtstrukturen mit photovoltaischer Funktion auf Glassubstraten sind bevorzugt Dünnschichtsolarzellen. Dünnschichtsolarzellen sind aus dünnen photoaktiven Schichten im Bereich von 100 nm bis 20 µm Schichtdicke aufgebaut. Die photoaktiven Schichten werden über Dünnschichtelektroden kontaktiert. Die photoaktiven Schichten beinhalten Halbleiter und Verbindungshalbleiter, Elektroden, transparente leitfähige Oxide oder Metallschichten. Photoaktive Schichten bestehen beispielsweise im Wesentlichen aus Silizium mit einer amorphen bis einkristallinen Struktur, aus dem Verbindungshalbleiter Cadmium-Tellurid oder insbesondere aus Verbindungen von Kupfer, Indium, Gallium, Selen oder Schwefel. Farbstoffsensibilisierte und organische Solarzellen bilden eine weitere Gruppe und werden ebenfalls in der Dünnschichtphotovoltaik eingesetzt. Durch Kombination von unterschiedlichen Halbleitern, insbesondere im Stapelaufbau, kann der elektrische Wirkungsgrad erhöht werden.

Schichtstrukturen mit Heizfunktion auf einer Fläche enthalten mindestens eine leitfähige Beschichtung, bevorzugt transparente Einzelschichten mit einem definierten elektrischen Schichtwiderstand. Durch Anlegen einer elektrischen Spannung an zwei gegenüberliegenden Randbereichen der Fläche, wird über Joulesche Wärme ein Heizeffekt erzielt. Die transparenten Heizschichten enthalten insbesondere Silber mit einer Schichtdicke von 5 nm bis 50 nm oder leitfähig transparenten Oxide wie Zinkoxid, Zinnoxid oder Indium-Zinn-Oxid.

Die mechanischen Spannungen der Verbundglasscheibe sind für Flächen >0,5m² minimiert. Insbesondere bei der erfindungsgemäßen Verwendung im Bauwesen mit typischen Größen von 1,5 x 2,5 m², 1,1 x 1,3 m² und 0,8 x 0,6 m² oder in der Verglasung von Fahrzeugen ist dies vorteilhaft.

Fahrzeuge sind Fahrzeuge zu Lande, zu Wasser und in der Luft. Insbesondere ist die Erfindung vorteilhaft in Kraftfahrzeugen zu verwenden.

Im Bauwesen ist die Erfindung insbesondere in der Architekturverglasung, für die Innenausstattung von Gebäuden, aber auch auf bewitterten Freiflächen vorteilhaft.

In einer bevorzugten Ausgestaltung weist das Deckglas auf der Polymer-Schicht zugewandten Seite eine passive Schicht zur Einstellung der Transmission von Wärmestrahlung auf. Die passive Schicht enthält bevorzugt dotierte Metalloxide, insbesondere SnO₂, ZnO, dünne transparente Metallschichten, insbesondere Silber, Metalloxide und / oder Siliziumnitrid, sowie Kombinationen davon. Über geeignete Schicht-Anordnungen kann mit der passiven Schicht das Reflektionsverhalten, Absorptionsverhalten, sowie die Emissivität der Schichten in einem definierten Wellenlängenbereich den Anforderungen der Verbundglasscheibe mit Schichtstruktur angepasst werden.

Wesentliche Anforderungen des Deckglases und des Substratglases sind deren thermischer Ausdehnungskoeffizient und die Korrisionstabilität. Insbesondere die Alkalielement-Oxide und Boroxide beeinflussen wesentlich die Eigenschaften. Vereinfacht führt eine Erhöhung des B₂O₃ Gehaltes im Deckglas oder Substratglas im Allgemeinen zu einer Erniedrigung des thermischen Ausdehnungskoeffizienten. Eine Erhöhung der Alkalielement-Oxide wie Li₂O, Na₂O, K₂O in der Glaszusammensetzung führt im Allgemeinen zu einer Erhöhung des mittleren thermischen Ausdehnungskoeffizienten. Geringe Gewichtsanteile an Alkalielement-Oxiden erhöhen die Korrosionsstabilität, insbesondere unter Einfluss von Feuchtigkeit und Wärme.

Das Deckglas und das Substratglas enthalten bevorzugt 0 Gew.-% bis 16 Gew.-% Alkalielement-Oxide und 5 Gew.-% bis 20 Gew.-% B₂O₃.
Besonders bevorzugt enthalten das Deckglas und das Substratglas 0,1 Gew.-% bis 6 Gew.-% Alkalielement-Oxide und 8 Gew.-% bis 15 Gew.-% B₂O₃.

Die Anforderungen hinsichtlich des mittleren thermischen Ausdehnungskoeffizienten werden somit eingestellt.

Die mindestens eine Polymerschicht als haftvermittelnde Schicht zwischen Substratglas, Schichtstruktur und Deckglas enthält bevorzugt Polyvinylbutyral (PVB), Polyurethan (PU), Polypropylen (PP), Polyacrylat, Polyethylen (PE), Polycarbonat (PC), Polymethylmetacrylat, Polyvinylchlorid, Polyacetatharz, Gießharze, Acrylate und / oder Ethylenvinylacetat (EVA), sowie deren Copolymere und / oder Mischungen davon.

Es folgt die Erläuterung der Erfindung anhand der Zeichnungen nach Aufbau und Wirkweise der dargestellten Erfindung.

Es zeigen
Figur 1 eine erfindungsgemäße Verbundglasscheibe mit einer Schichtstruktur,
Figur 2 eine bevorzugte Ausführungsform der Verbundglasscheibe,
Figur 3 eine sphärische Darstellung einer Verbundglasscheibe.

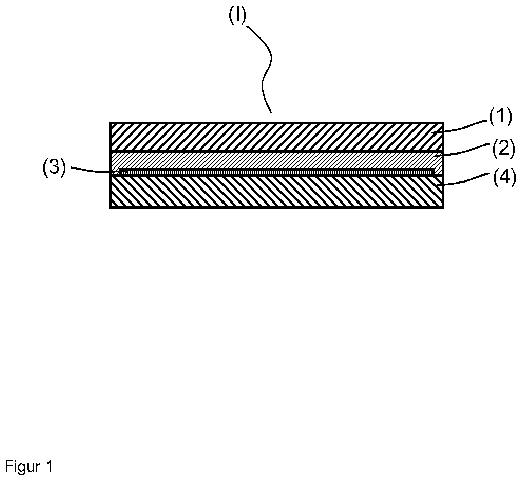

In Figur 1 ist ein Ausführungsbeispiel der erfindungsgemäßen Verbundglasscheibe (I) dargestellt. Als Schichtstruktur (3) wurde eine Schichtfolge mit elektrochromer Funktion auf einem Substratglas (4) aufgebracht. Die Dicke der Schichtstruktur (3) betrug 0,5 bis 2 µm. Das Substratglas (4) war ein Borosilikatglas mit einer Dicke von 1,5 mm. Der mittlere thermische Ausdehnungskoeffizient betrug 44 x 10⁻⁷ K⁻¹, gemessen nach DIN ISO 7991. Als Deckglas (1) wurde ein optimiertes Borosilikatglas mit einer Dicke von 6 mm und einem mittleren thermischen Ausdehnungskoeffizienten von 50 x 10⁻⁷ K⁻¹ verwendet. Der mittlere thermische Ausdehnungskoeffizient des Substratglases (4) war 6 x 10⁻⁷ K⁻¹ kleiner als der mittlere thermische Ausdehnungskoeffizient des Deckglases (1). Als Polymerschicht (2) für den Verbundaufbau zwischen der Schichtstruktur (3) und dem Deckglas (1) wurde eine Polyurethanfolie der Firma Huntsmann, Salt Lake City, mit einem thermischen Ausdehnungskoeffizienten von etwa 800 x 10⁻⁷ K⁻¹ und einer Dicke von 0,76 mm verwendet. Die Fläche der Verbundglasscheibe (I) betrug 1,5 m x 2, 5 m. Die mechanischen Spannungen in der Verbundglasscheibe (I) wurden mit einem Simulationsprogramm ABAQUS V. 6.8, der Firma Dassault Systems berechnet. Für die Berechnungen der maximalen Spannungen und Verbiegungen wurde ein Temperaturbereich von -40°C bis 90°C zugrunde gelegt. Die maximalen mechanischen Spannungen in der Verbundglasscheibe (I) wurden mit 7 MPa berechnet, die resultierende maximale Verbiegung betrug 7 mm. Die resultierenden Spannungen waren in allen Bereichen kleiner 7 MPa. Insbesondere im Bereich der Schichtstruktur (3) traten keine mechanischen Spannungen auf, die zur Delamination der Schichtstruktur führten.

Ein Vergleichsbeispiel gemäß dem Stand der Technik betrifft eine Verbundglasscheibe, die sich wie folgt von den erfindungsgemäßen Verbundglasscheiben (I) unterschied. Das Substratglas (4) war ein Borosilikatglas mit einer Dicke von 6 mm. Der mittlere thermische Ausdehnungskoeffizient betrug 32 x 10⁻⁷ K⁻¹, gemessen nach DIN ISO 7991. Als Deckglas (1) wurde ein Natron-Kalk Glas mit einer Dicke von 10 mm und einem mittleren thermische Ausdehnungskoeffizienten von 90 x 10⁻⁷ K⁻¹ verwendet. Der mittlere thermische Ausdehnungskoeffizient des Substratglases (4) war 58 x 10⁻⁷ K⁻¹ kleiner als der mittlere thermische Ausdehnungskoeffizient des Deckglases (1). Die maximalen mechanischen Spannungen innerhalb der Verbundglasscheibe (I) wurden mit 35 MPa berechnet. Die resultierende maximale Verbiegung betrug 67 mm. Die resultierenden Spannungen sind in kritischen Bereichen größer als 7 MPa. Insbesondere an den innen liegenden Oberflächen der Schichtstruktur (3) traten Zug- und Druckspannungen und in der Folge Scherkräfte auf, die zur Delamination der Schichtstruktur (3) an den Grenzflächen führten.

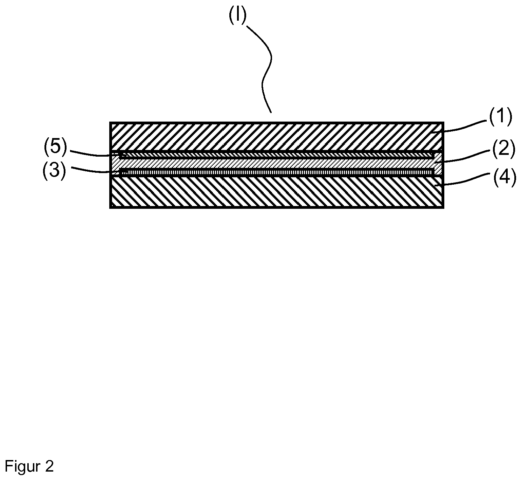

Figur 2 zeigt eine bevorzugte Ausführungsform der Erfindung. Auf dem Deckglas (1) befindet sich eine passive Schicht (5). Die passive Schicht (5) enthält eine Infrarotstrahlung reflektierende Beschichtung. Die mechanischen Eigenschaften sind dem Ausführungsbeispiel aus Figur 1 in etwa gleich.

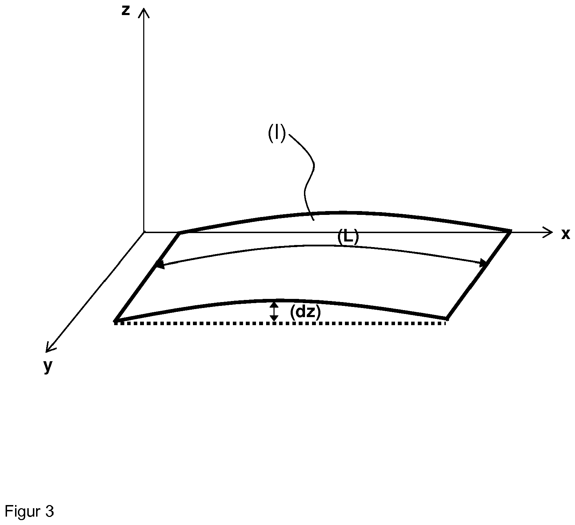

Figur 3 zeigt die sphärische Darstellung einer Verbundglasscheibe (I). (L) ist die längste Kante der Verbundglasscheibe (I). Die maximale Verbiegung (dz) der Verbundglasscheibe (I) sollte kleiner oder gleich 1/150 von (L) betragen um Delamination, Deformation oder Glasbruch der Verbundglasscheibe (I) zu verhindern.

In der Tabelle 1 sind weitere Ausführungsbeispiele als bevorzugte Konfigurationen und Vergleichsbeispiele nach dem Stand der Technik gezeigt, wobei die Ausführungen 3 und 7 nicht beansprucht werden. Die Verbundglasscheiben hatten eine Fläche von 1,5 x 2,5 m². (CTE) bezeichnet die mittleren thermischen Ausdehnungskoeffizienten und (d) die Dicke der Polymerschichten, beziehungsweise der Glasscheiben. Die Simulationsergebnisse der maximalen mechanischen Spannungen innerhalb der Schichtstruktur sind als Sigma bezeichnet. Die Verbiegung (dz) gibt die maximale Tiefe einer konvexen Form oder Höhe einer konkaven Form bezogen auf eine planare Ebene an. Es wurde ein Temperaturbereich von -40°C bis +90 °C für die Ermittlung der maximalen Spannungen berücksichtigt. Für alle Beispiele wurde eine 0,76 mm dicke Polyurethanfolie als Polymerschicht (2) verwendet. Die Ergebnisse in Tabelle 2 zeigen weitere nicht beanspruchte Ausführungsformen mit Verbundglasscheiben einer Fläche von 1,1 x 1,3 m².

**Tabelle 1**

| | | Substratglas (4) | | Deckglas (1) | | Betrag der Differenz | Ergebnis | |
|---|---|---|---|---|---|---|---|---|
| Nr. | Beispiel | d [mm] | CTE [10⁻⁷K⁻¹] | d [mm] | CTE [10⁻⁷K⁻¹] | CTE(1)-CTE(4) [10⁻⁷K⁻¹] | Sigma [MPa] | dz [mm] |
| 1. | Vergleich | 6 | 32 | 10 | 90 | 58 | 35 | 67 |
| 2. | Vergleich | 6 | 44 | 10 | 90 | 46 | 27 | 53 |
| 3. | Ausführung | 6 | 32 | 10 | 37 | 5 | 7 | 12 |
| 4. | Ausführung | 6 | 44 | 10 | 50 | 6 | 7 | 12 |
| 5. | Ausführung | 1,5 | 44 | 4 | 50 | 6 | 7 | 13 |
| 6. | Ausführung | 1,5 | 44 | 6 | 50 | 6 | 7 | 7 |
| 7. | Ausführung | 6 | 32 | 10 | 44 | 12 | 7 | 14 |

**Tabelle 2**

| | | Substratglas (4) | | Deckglas (1) | | Betrag der Differenz | Ergebnis | |
|---|---|---|---|---|---|---|---|---|
| Nr. | Beispiel | d [mm] | CTE [10⁻⁷K⁻¹] | d [mm] | CTE [10⁻⁷K⁻¹] | CTE(1)-CTE(4) [10⁻⁷K⁻¹] | Sigma [MPa] | dz [mm] |
| 8. | Ausführung | 6 | 44 | 1,5 | 32 | 12 | 7 | 6,1 |
| 9. | Ausführung | 1,5 | 44 | 6 | 32 | 12 | 7 | 8,9 |

In den Vergleichsbeispielen 1 und 2 traten insbesondere an den innen liegenden Oberflächen der Schichtstruktur (3) hohe mechanische Spannungen von 27 und 35 MPa und Biegungen von 53 und 67 mm auf. Die resultierenden Scherkräfte führten zur Delamination der Schichtstruktur an den Grenzflächen.

In den erfindungsgemäßen Ausführungsbeispielen 4bis 6 traten mechanische Spannungen von maximal 7 MPa und Biegungen von 7 mm bis 14 mm auf. Insbesondere im Bereich der Schichtstruktur (3) traten keine mechanische Spannungen auf, die zur Delamination der Schichtstruktur (3), Deformation oder Bruch der Verbundglasscheibe (I) führten.

Die Ergebnisse der Tabellen 1 und 2 zeigen, dass sich für die erfindungsgemäßen Verbundglasscheiben (I) mit Schichtstruktur (3) wesentlich reduzierte maximale mechanische Spannungen ergeben. Insgesamt ist die Wahrscheinlichkeit von Verformungen, Delaminationen und Glasbruch in Folge von Temperaturänderungen und / oder äußeren Kräften der Verbundglasscheibe (I) minimiert.

### Bezugszeichenliste:

(I) Verbundglasscheibe
   (1) Deckglas
   (2) Polymerschicht
   (3) Schichtstruktur
   (4) Substratglas
   (5) Passive Schicht
(L) Länge der längsten Kante der Verbundglasscheibe
(dz) Maximale Verbiegung der Verbundglasscheibe

## Patentansprüche

1. Verbundglasscheibe (I), umfassend
a) ein Substratglas (4) mit einer Dicke von 0,3 mm bis 25 mm,
b) mindestens eine auf dem Substratglas (4) aufgebrachte Schichtstruktur (3),
c) mindestens eine auf der Schichtstruktur (3) aufgebrachte Polymerschicht (2) mit einer Schichtdicke von 0,2 mm bis 10 mm,
d) ein Deckglas (1) mit einer Dicke von 1,3 mm bis 25 mm auf der Polymerschicht (2),
wobei im Temperaturbereich von -40 °C bis +90 °C die maximale mechanische Spannung der Verbundglasscheibe (I) kleiner oder gleich 7 MPa ist und wobei das Substratglas (4) ein Borosilikatglas ist mit einem mittleren thermischen Ausdehnungskoeffizienten von 44 x 10⁻⁷ K⁻¹ und wobei das Deckglas (1) ein Borosilikatglas ist mit einem mittleren thermischen Ausdehnungskoeffizienten von 50 x 10⁻⁷ K⁻¹.

2. Verbundglasscheibe (I) nach Anspruch 1 , wobei die maximale Verbiegung (dz) im Temperaturbereich von -40 °C bis +90 °C der Verbundglasscheibe (I) kleiner oder gleich 16 mm ist.

3. Verbundglasscheibe (I) nach Anspruch 1 oder 2, wobei das Substratglas (4) und das Deckglas (1) 0 Gew.-% bis 18 Gew.-% Alkalielement-Oxide und 5 Gew.-% bis 20 Gew.-% B₂O₃, bevorzugt 0,1 Gew.-% bis 6 Gew.-% Alkalielement-Oxide und 8 Gew.-% bis 15 Gew.-% B₂O₃ enthalten.

4. Verbundglasscheibe (I) nach einem der Ansprüche 1 bis 3, wobei die Polymerschicht (2) Polyvinylbutyral (PVB), Polyurethan (PU), Polypropylen (PP), Polyacrylat, Polyethylen (PE), Polycarbonat (PC), Polymethylmethacrylat Polyvinylchlorid, Polyacetatharz, Gießharze, Acrylate und / oder Ethylenvinylacetat (EVA), sowie deren Copolymere und / oder Mischungen davon enthält.

5. Verbundglasscheibe (I) nach einem der Ansprüche 1 bis 4, wobei das Deckglas (1) zusätzlich eine passive Schicht (5) umfasst, enthaltend Metalloxide, Silber, Metalloxide, Siliziumnitride und / oder Siliziumoxide, sowie Kombinationen davon.

6. Verbundglasscheibe (I) nach einem der Ansprüche 1 bis 5, wobei die Schichtstruktur (3) mindestens eine elektrisch leitende und / oder halbleitende Schicht enthält.

7. Verbundglasscheibe (I) nach einem der Ansprüche 1 bis 6, wobei die Schichtstruktur (3) ein photoaktives Schichtsystem mit einer Schichtdicke von 100 nm bis 20 µm enthält.

8. Verbundglasscheibe (I) nach einem der Ansprüche 1 bis 7, wobei die Schichtstruktur (3) ein lichtemittierendes Schichtsystem mit einer Schichtdicke von 500 nm bis 2 mm enthält.

9. Verbundglasscheibe (I) nach einem der Ansprüche 1 bis 8, wobei die Schichtstruktur (3) ein elektrochromes Schichtsystem mit einer Schichtdicke von 500 nm bis 1 mm enthält.

10. Verbundglasscheibe (I) nach einem der Ansprüche 1 bis 9, wobei die Schichtstruktur (3) mindestens eine Silberschicht mit einer Schichtdicke von 5 nm bis 50 nm enthält.

11. Verwendung einer Verbundglasscheibe (I) nach einem der Ansprüche 1 bis 10 als elektrochrome Verglasung zur Steuerung der Transmission elektromagnetischer Strahlung durch die Verglasung.

12. Verwendung einer Verbundglasscheibe (I) nach einem der Ansprüche 1 bis 10 als Dünnschicht-Photovoltaik-Modul im Bauwesen, auf der Freifläche oder im Fahrzeugbereich.

## Claims

1. Composite glass pane (I), comprising
a) a substrate glass (4) with a thickness of 0.3 mm to 25 mm,
b) at least one layer structure (3) applied on the substrate glass (4),
c) at least one polymeric layer (2) with a layer thickness of 0.2 mm to 10 mm applied on the layer structure (3),
d) a cover glass (1) with a thickness of 1.3 mm to 25 mm on the polymeric layer (2),
wherein in the temperature range from -40 °C to +90 °C, the maximum mechanical stress of the composite glass pane (I) is less than or equal to 7 MPa and wherein the substrate glass (4) is a borosilicate glass with a mean coefficient of thermal expansion of 44 x 10⁻⁷ K⁻¹, and wherein the cover glass (1) is a borosilicate glass with a mean coefficient of thermal expansion of 50 x 10⁻⁷ K⁻¹.

2. Composite glass pane (I) according to claim 1, wherein the maximum deflection (dz) in the temperature range from -40 °C to +90 °C of the composite glass pane (I) is less than or equal to 16 mm.

3. Composite glass pane (I) according to claim 1 or 2, wherein the substrate glass (4) and the cover glass (1) contain 0 wt.-% to 18 wt.-% alkali element oxides and 5 wt.-% to 20 wt.-% B₂O₃, preferably 0.1 wt.-% to 6 wt.-% alkali element oxides and 8 wt.-% to 15 wt.-% B₂O₃.

4. Composite glass pane (I) according to one of claims 1 through 3, wherein the polymeric layer (2) contains polyvinyl butyral (PVB), polyurethane (PU), polypropylene (PP), polyacrylate, polyethylene (PE), polycarbonate (PC), polymethyl methacrylate, polyvinyl chloride, polyacetate resin, casting resins, acrylates, and / or ethylene vinyl acetate (EVA), as well as their copolymers and / or mixtures thereof.

5. Composite glass pane (I) according to one of claims 1 through 4, wherein the cover glass (1) additionally comprises a passive layer (5), containing metal oxides, silver, metal oxides, silicon nitrides, and / or silicon oxides, as well as combinations thereof.

6. Composite glass pane (I) according to one of claims 1 through 5, wherein the layer structure (3) includes at least one electrically conducting and / or semiconducting layer.

7. Composite glass pane (I) according to one of claims 1 through 6, wherein the layer structure (3) includes a photoactive layer system with a layer thickness of 100 nm to 20 µm.

8. Composite glass pane (I) according to one of claims 1 through 7, wherein the layer structure (3) includes a light-emitting layer system with a layer thickness of 500 nm to 2 mm.

9. Composite glass pane (I) according to one of claims 1 through 8, wherein the layer structure (3) includes an electrochromic layer system with a layer thickness of 500 nm to 1 mm.

10. Composite glass pane (I) according to one of claims 1 through 9, wherein the layer structure (3) includes at least one silver layer with a layer thickness of 5 nm to 50 nm.

11. Use of a composite glass pane (I) according to one of claims 1 through 10 as electrochromic glazing for controlling the transmittance of electromagnetic radiation through the glazing.

12. Use of a composite glass pane (I) according to one of claims 1 through 10 as a thin-film photovoltaic module in the building industry, in open areas, or in the motor vehicle sector.

## Revendications

1. Vitre en verre feuilleté (I), comportant
a) un verre de substrat (4) ayant une épaisseur de 0,3 mm à 25 mm ;
b) au moins une structure feuilletée (3) appliquée sur le verre de substrat (4) ;
c) au moins une couche polymère (2) appliquée sur la structure feuilletée (3), ayant une épaisseur de couche de 0,2 mm à 10 mm ;
d) un verre de couverture (1) ayant une épaisseur de 1,3 mm à 25 mm sur la couche polymère (2),
dans laquelle, dans le domaine de température de -40°C à +90°C, la contrainte mécanique maximale de la vitre en verre feuilleté (I) est inférieure ou égale à 7 Mpa,
et dans laquelle le verre de substrat (4) est un verre borosilicaté ayant un coefficient de dilatation thermique moyen de 44 x 10⁻⁷ K⁻¹, et dans laquelle le verre de couverture (1) est un verre borosilicaté ayant un coefficient de dilatation thermique moyen de 50 x 10⁻⁷ K⁻¹.

2. Vitre en verre feuilleté (I) selon la revendication 1, dans laquelle la déflexion maximale (dz) dans le domaine de température de -40°C à +90°C de la vitre en verre feuilleté (I) est inférieure ou égale à 16 mm.

3. Vitre en verre feuilleté (I) selon l'une des revendications 1 ou 2, dans laquelle le verre de substrat (4) et le verre de couverture (1) contiennent 0 % en masse à 18 % en masse d'oxydes d'éléments alcalins et 5 % en masse à 20 % en masse de B₂O₃, de préférence 0,1 % en masse à 6 % en masse d'oxydes d'éléments alcalins et 8 % en masse à 15 % en masse de B₂O₃.

4. Vitre en verre feuilleté (I) selon l'une des revendications 1 à 3, dans laquelle la couche polymère (2) contient du polyvinyl butyral (PVB), du polyuréthane (PU), du polypropylène (PP), du polyacrylate, du polyéthylène (PE), du polycarbonate (PC), du poly(méthacrylate de méthyle), du poly(chlorure de vinyle), de la résine de polyacétate, des résines à couler, des acrylates et/ou de l'éthylène-acétate de vinyle (EVA), ainsi que leurs copolymères et/ou leurs mélanges.

5. Vitre en verre feuilleté (I) selon l'une des revendications 1 à 4, dans laquelle le verre de couverture (1) comporte en outre une couche passive (5), contenant des oxydes métalliques, de l'argent, des oxydes métalliques, des nitrures de silicium et/ou des oxydes de silicium, ainsi que leurs combinaisons.

6. Vitre en verre feuilleté (I) selon l'une des revendications 1 à 5, dans laquelle la structure feuilletée (3) contient au moins une couche conductrice et/ou semiconductrice de l'électricité.

7. Vitre en verre feuilleté (I) selon l'une des revendications 1 à 6, dans laquelle la structure feuilletée (3) contient un système à couches photoactif ayant une épaisseur de couches de 100 nm à 20 µm.

8. Vitre en verre feuilleté (I) selon l'une des revendications 1 à 7, dans laquelle la structure feuilletée (3) contient un système à couches à émission de lumière ayant une épaisseur de couches de 500 nm à 2 mm.

9. Vitre en verre feuilleté (I) selon l'une des revendications 1 à 8, dans laquelle la structure feuilletée (3) contient un système à couches électrochrome ayant une épaisseur de couches de 500 nm à 1 mm.

10. Vitre en verre feuilleté (I) selon l'une des revendications 1 à 9, dans laquelle la structure feuilletée (3) contient au moins une couche d'argent ayant une épaisseur de couche de 5 nm à 50 nm.

11. Utilisation d'une vitre en verre feuilleté (I) selon l'une des revendications 1 à 10 en tant que vitrage électrochrome pour la commande de la transmission de rayonnement électromagnétique à travers le vitrage.

12. Utilisation d'une vitre en verre feuilleté (I) selon l'une des revendications 1 à 10 en tant que module photovoltaïque à couche mince dans l'industrie du bâtiment, dans les espaces libres ou dans le secteur automobile.
